# EUROPEAN PATENT APPLICATION

(11) **EP 4 470 720 A1**
(43) Date of publication of application: **04.12.2024**
(21) Application number: 23742736.4
(22) Date of filing: 09.01.2023
(51) Int. Cl.: B24B 37/005, B24B 49/12, B24B 37/26, H01L 21/66

(54) **ONLINE DETECTION METHOD AND SYSTEM FOR SURFACE CONDITION OF POLISHING PAD**

(30) Priority: 24.01.2022 CN 202210077397
(71) Applicant: Hangzhou Sizone Electronic Technology Inc., Hangzhou Zhejiang 311300 (CN)
(72) Inventor: YANG, Zhe, hangzhou, Zhejiang 311300 (CN); ZHOU, Yuanpeng, hangzhou, Zhejiang 311300 (CN); CAI, Ningyuan, hangzhou, Zhejiang 311300 (CN)
(74) Representative: Becker, Eberhard
(86) International application number: PCT/CN2023/071164
(87) International publication number: WO 2023/138421

(57) **Abstract**

An online detection method and system for the surface condition of a polishing pad. The online detection method comprises the following steps: an optical sensor (1) moving above a polishing pad (2), so as to acquire distance information between the optical sensor (1) and the surface of the polishing pad (2); according to the measured distance information, distinguishing distribution conditions of liquid on the surface of the polishing pad (2), and correspondingly using different correction calculation formulas to calculate a depth value of a trench (21) in the surface of the polishing pad (2); comparing a corrected depth value of the trench (21) in the surface of the polishing pad (2) with a preset threshold value; and determining the depth condition of the trench (21) in the surface of the polishing pad (2), so as to determine whether the polishing pad (2) needs to be replaced.

## Description

### Technical Field

The invention belongs to the field of semiconductor integrated circuit chip manufacturing equipment, and particularly relates to a method and system for online inspection of surface condition of polishing pads.

### Background Art

Chemical mechanical planarization (CMP) is an important step in the current semiconductor integrated circuit chip manufacturing process. The CMP process utilizes polishing pads and polishing slurry to grind wafers or thin films on the wafers, achieving surface planarization by combining mechanical and chemical actions. The polishing pads have a surface with certain roughness for mechanical grinding, and are designed with groove patterns to retain slurry on the surface of the polishing pads. The polishing slurry makes contact with the wafers along the groove patterns to perform chemical etching.

With the progress of the planarization, the surface of the polishing pad gradually wears down due to continuous grinding. This leads to a reduction in the thickness of the polishing pad and shallower groove patterns on its surface. The reduced capacity of the shallower grooves to hold the polishing slurry can result in a change in the grinding rate, and the worn-out grooves can cause an increase of process variation and an increased risk of wafer handling reliability. Therefore, it is essential to detect the surface condition of the polishing pad.

Currently, there are several methods for assessing the surface condition of the polishing pad.
1. Based on the working time of the polishing pad or the number of wafers polished. This method can automatically give a notification when a set time or wafer quantity is reached. However, this method solely relies on an experimental judgment, and there can be inconsistencies between actual conditions and experimental conditions due to different process flows, parameters, wafer types, and variations in the polishing pad itself, which may lead to incorrect assessments.
2. Employing manual visual inspection or tool-based inspection during online or downtime maintenance. However, the manual visual inspection method consumes a large amount of manpower and only provides qualitative, not quantitative, evaluation with a significant margin of error, thus resulting in inadequate accuracy. In addition, equipment maintenance reduces tool utilization time, and long intervals between maintenances can lead to a delay in assessments.
3. Indirect judgment based on the thickness of the polishing pad. This method involves measuring the position of a dresser and other structures in contact with the polishing pad to obtain information on the thickness of the polishing pad. Alternatively, the thickness of the polishing pad can be obtained by measuring the transmittance of the polishing pad. However, this method provides limited information about the condition of the polishing pad, capable of generating local thickness information but incapable of collecting actual groove depth information. This method is also ineffective in detecting other factors/errors which only affect the depth control of the grooves themselves.

### SUMMARY OF THE INVENTION

To overcome the limitations of the prior art, the invention provides a method and system for real-time online inspection of a surface condition of a polishing pad, enabling the measurement of groove depth with consideration of liquid on pad surface, so as to enhance the efficiency and yield of the chemical mechanical planarization process.

The technical scheme adopted by the invention to solve the technical problems is as follows. A method for online inspection of a surface condition of a polishing pad, comprises the following steps:
moving an optical sensor above the polishing pad to obtain a distance measurement between the optical sensor and the surface of the polishing pad;
analyzing distribution of the liquid on the surface of the polishing pad based on the distance measurement, and calculating a depth of the grooves on the surface of the polishing pad using different modified calculation formulas; and
comparing the depths of the grooves on the surface of the polishing pad with a predetermined threshold value, and determining whether the polishing pad needs to be replaced or reworked.

Further, comparing the depths of the grooves on the surface of the polishing pad with a predetermined threshold value is to determine whether number of the grooves with the depths of the grooves less than the predetermined threshold value reaches a set number, or to determine whether an average value of the depths of the grooves in a specified range is less than the predetermined threshold value.

Further, the distance measurement between the optical sensor and the surface of the polishing pad acquired during movement of the optical sensor is used as a so-called first information;
or/and a distance measurement between the optical sensor and a surface of the liquid on the polishing pad acquired during movement of the optical sensor is used as a second information;
or/and a distance measurement between the optical sensor and a bottom surface of the grooves acquired during movement of the optical sensor is used as a third information;
or/and a distance measurement between the optical sensor and a liquid surface in the grooves acquired during movement of the optical sensor is used as the fourth information.

Further, distribution patterns of the liquid on the surface of the polishing pad comprise at least one of the following three cases:
in a first case, the liquid is present in the grooves, and overflows to cover the surface of the polishing pad;
in a second case, the liquid is present in the grooves, but the grooves are not completely filled; and
in a third case, the liquid is not present in the grooves.

Further, the optical sensor analyzes the distribution of the liquid on the surface of the polishing pad:
in the first case, the first information, the second information, the third information and the fourth information are acquired;
in the second case, the first information, the third information and the fourth information are acquired; and
in the third case, the first information and the third information are acquired.

Further, in the first case, the depths of the grooves = the measured depths of the grooves × liquid refractive index;
in the second case, the depths of the grooves = the measured depths of the grooves + (the distance between the optical sensor and the bottom surface of the grooves - the distance between the optical sensor and the liquid surface on the polishing pad) × (liquid refractive index-1); and
in the third case, the depths of the grooves = the measured depths of the grooves.

Further, the above steps are repeated, and when the depths condition of the grooves reach a predetermined condition, a warning for replacing the polishing pad is given.

Further, the optical sensor moves above the polishing pad in a direction which is parallel to and above the polishing pad, and the moving range traverses from a periphery of the polishing pad to a center of the polishing pad.

The invention further discloses a system for online inspection of a surface condition of a polishing pad, comprising:
an optical sensor at least comprising an optical unit, a sensor probe and a control unit,
the optical unit being used for emitting a light beam to a surface of the polishing pad,
the sensor probe being used for focusing the light beam emitted by the optical unit and directing the light beam on the polishing pad, and receiving a reflected light signal and transmitting the reflected light signal to the optical unit, and
the control unit being used for acquiring distances information between the sensor probe and the surface of the polishing pad;
a processing unit connected with the optical sensor and used for analyzing the distance information between the sensor probe and the surface of the polishing pad and calculating a depth of the grooves on the surface of the polishing pad according to different modified calculation formulas; and
a movable support structure used for driving the optical sensor to move above the polishing pad.

Further, the modified calculation formulas correspond to a distribution pattern of a liquid on the surface of the polishing pad, and the distribution patterns comprise the following:
in a first case, the liquid is present in the grooves, and overflows to cover the surface of the polishing pad;
in a second case, the liquid is present in the grooves, but the grooves are not completely filled; and
in a third case, the liquid is not present in the grooves.

Further, the optical sensor adopts a spectral confocal technology.

Further, the movable support structure drives the optical sensor to move in a direction which is mostly parallel to the polishing pad, from a periphery to a center of the polishing pad, and a height of the movable support structure is adjustable.

Further, the movable support structure is a polishing head, or a polishing arm, or a polishing slurry distribution arm, or a dressing head, or a dressing arm, or an independent support structure.

Further, the sensor probe is covered with a transparent protective layer, and the system further comprises a cleaning unit for cleaning the sensor probe or the transparent protective layer.

Further, the system comprises a warning unit which gives a warning signal when an average value of the depths of the grooves in a specified range is less than a predetermined value or a number of the grooves have the depths of the grooves less than a predetermined threshold value.

The merits of the invention are as follows. 1) According to the method and system for online inspection of the surface condition of the polishing pad, a non-contact online inspection of the surface condition of the polishing pad is realized by using the optical sensor, eliminating potential damage to the surface of the polishing pad caused by alternative contact inspection methods. In addition, the online measurement enables timely monitoring of the surface condition of the polishing pad. Compared with manual inspection with low efficiency and experimental time-based inspection with low accuracy, the inspection system can accurately and efficiently inspect the surface condition of the polishing pad. 2) Based on measurement of the distance between the polishing pad and the bottom of the groove, a precise quantitative value of the groove depth can be obtained. By utilizing the movable support structure, the optical sensor can traverse the entire polishing pad, so as to accurately measure the depths of all the grooves on the polishing pad. In comparison to a localized thickness detection of the polishing pad, the invention enables accurate measurement of the overall and localized surface condition of the polishing pad. 3) The distance measurement method of the invention allows detection of the presence of liquid surface on the polishing pad. While detecting the depth of the groove on the polishing pad, it also monitors the liquid status on the surface of the polishing pad, and determines the amount of liquid. Based on the liquid status on the surface of the polishing pad, the depth of the groove on the polishing pad can be obtained through modified inspection. 4) Based on the distribution patterns of surface liquid in different areas of the polishing pad and the distance information, precise depth values of the grooves in each area can be obtained, resulting in more accurate assessments. 5) The movable support structure can drive the optical sensor to move in real time to inspect the polishing pad, enhancing timeliness in inspection and facilitating timely replacement of the polishing pad.

### BRIEF DESCRIPTION OF THE DRAWINGS

FIG. 1 is a schematic perspective view of a polishing system according to the invention.
FIG. 2 is a schematic diagram showing the combination of a system for online inspection of a surface condition of a polishing pad and chemical mechanical planarization equipment according to the invention.
FIG. 3 is a schematic diagram of a system for online inspection of a surface condition of a polishing pad according to the invention.
FIG. 4 is a schematic diagram of surface characteristics of a polishing pad and inspection thereof, with a surface of the polishing pad covered with liquid.
FIG. 5 is a schematic diagram showing that a surface of a polishing pad is covered with liquid.
FIG. 6 is a schematic diagram showing that liquid is only present in a groove.
FIG. 7 is a schematic diagram showing that no liquid is present on a surface of a polishing pad.
FIG. 8 is a block diagram of a method for online inspection of a surface condition of a polishing pad according to the invention.

### DETAILED DESCRIPTION OF THE EMBODIMENTS

For people skilled in the art to better understand the scheme of the invention, the technical scheme in the embodiments of the invention will be clearly and completely described below in combination with attached drawings. Obviously, the described embodiments are only part of the embodiments of the invention, not all of them. Based on the embodiments of the invention, all other embodiments obtained by those of ordinary skill in the art without making creative labor shall belong to the scope of protection of the invention.

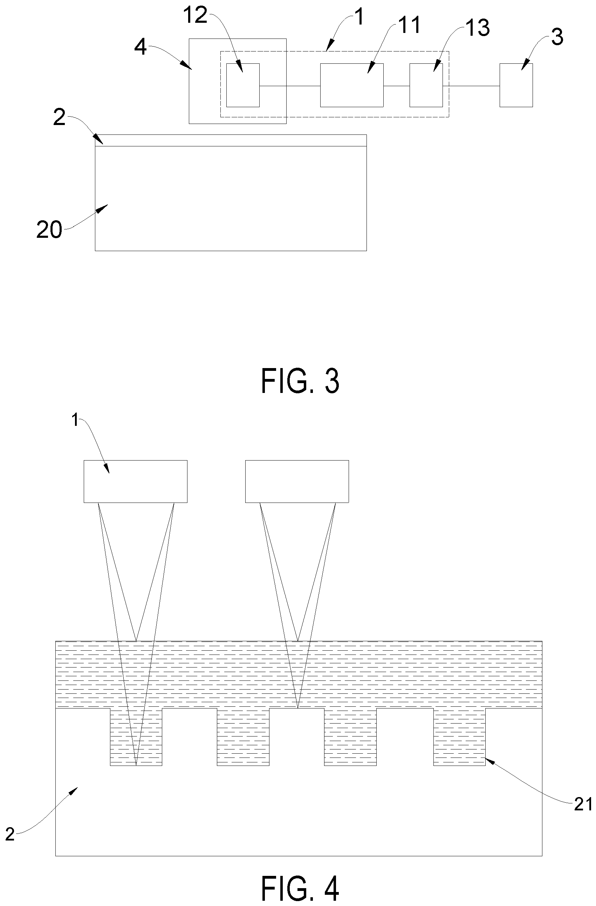

A system for online inspection of a surface condition of a polishing pad comprises an optical sensor 1, a processing unit 3, a movable support structure 4, and a warning unit, as shown in FIG. 3.

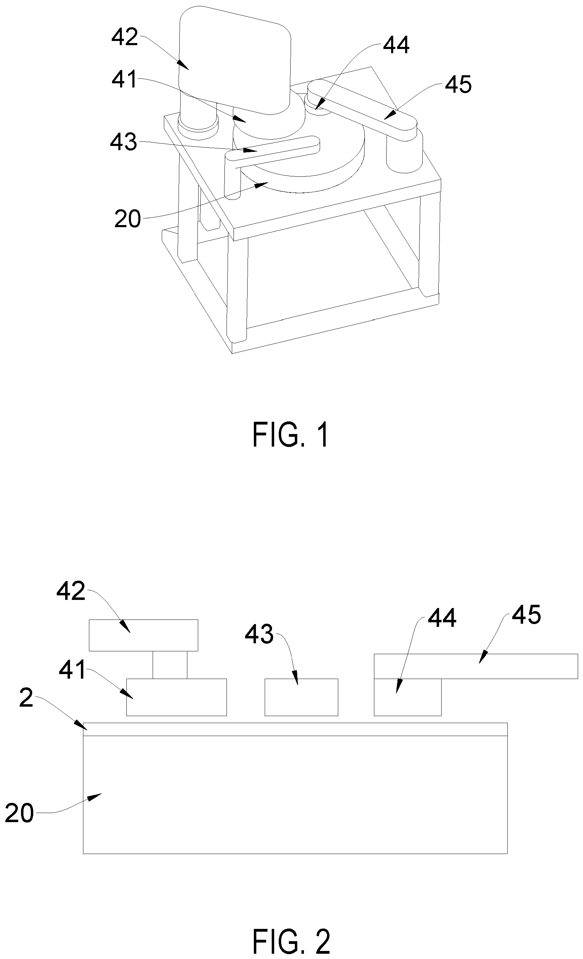

As shown in FIGs. 1 and 2, the polishing pad 2 is installed on a surface of a polishing table 20 to rotate with the polishing table 20, and a polishing head 41, a polishing arm 42, a polishing slurry distribution arm 43, a dressing head 44 and a dressing arm 45 are installed above the polishing table 20. The polishing head 41 fixes wafers, and allows the wafers to make sufficient contact with the polishing pad 2 and move and rotate relative to the polishing table 20. The polishing arm 42 fixes the polishing head 41. The polishing slurry distribution arm 43 supplies polishing slurry to a surface of the polishing pad 2. The dressing head 44 contacts the polishing pad 2 to dress the surface of the polishing pad 2. The polishing arm 42 fixes the polishing head 41. FIG. 1 shows only one of the polishing forms, but in other embodiments, other existing polishing forms may be adopted.

The optical sensor 1 is used for on-line inspection of a target distance from surface characteristics of the polishing pad 2, and at least comprises an optical unit 11, a sensor probe 12, and a control unit 13. In this embodiment, the optical sensor 1 adopts spectral confocal technology.

The optical unit 11 is used for emitting a light beam to the surface of the polishing pad 2.

The sensor probe 12 is used for focusing the light beam emitted by the optical unit 11 and shining the light beam on the polishing pad 2, and receiving reflected light and transmitting the reflected light to the optical unit 11. The sensor probe 12 may not only be integrated in the optical sensor 1, but also exist independently of the optical sensor 1.

A cleaning unit is installed above the polishing table 20, which is used for cleaning the sensor probe 12 to prevent possible liquid crystallization. In order to well protect the sensor probe 12, the sensor probe 12 is covered with a transparent protective layer to prevent possible liquid pollution and corrosion. The cleaning unit can clean the transparent protective layer.

The control unit 13 is used for acquiring distances between the sensor probe 12 and all parts of the surface of the polishing pad 2.

The processing unit 3 is connected with the optical sensor 2 and used for analyzing the distance information acquired by the control unit 13 and calculating depths of grooves 21 on the surface of the polishing pad 2 according to different modified calculation formulas.

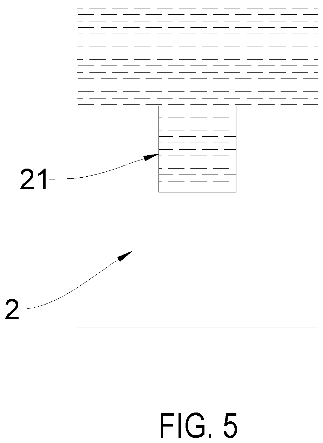

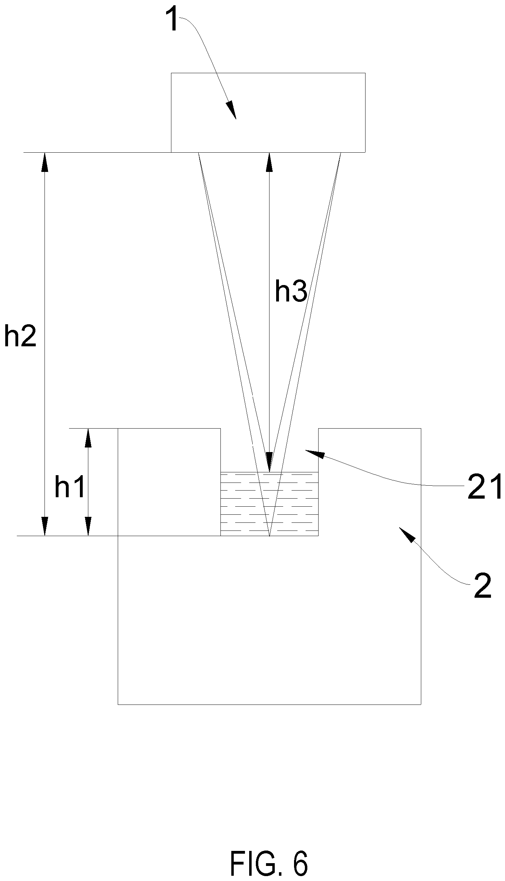

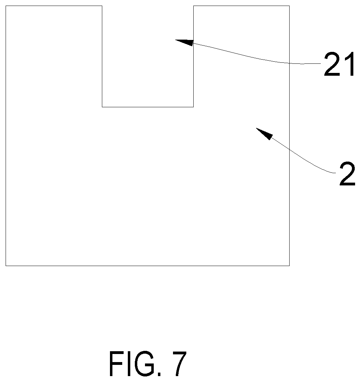

The modified calculation formulas correspond to different distribution patterns of liquid on the surface of the polishing pad 2, and the distribution patterns comprise the following: in a first case, the liquid is present in the grooves 21, and overflows to cover the surface of the polishing pad 2, that is, a liquid surface exists on the polishing surface of the polishing pad 2 and in the grooves 21, as shown in FIG. 5; in a second case, the liquid is present in the grooves 21, but the grooves 21 are not completely filled, that is, the liquid surface exists in the grooves 21, but does not exist on the polishing surface of the polishing pad 2, as shown in FIG. 6; and in a third case, no liquid is present in the grooves 21, and there is no liquid surface on the polishing surface of the polishing pad 2 or in the grooves 21, as shown in FIG. 7.

The movable support structure 4 is used for driving the optical sensor 1 to move above the polishing pad 2. That is, the optical sensor 1 follows the movable support structure 4 and moves in a direction parallel to the polishing pad 2, and the movement covers the entire range from a periphery to a center of the polishing pad 2.

The optical sensor 1 measures a distance between the sensor probe 12 and the surface of the polishing pad 2. According to this distance, the movable support structure 4 drives the sensor probe 12 fixed thereon to move in a direction perpendicular to the polishing pad 2, so that the distance between the sensor probe 12 and the surface of the polishing pad 2 can be adjusted to the optimal working distance of the optical sensor 1. At the optimal working distance, a focusing point of the light beam emitted by the sensor probe 12 is the smallest, and can enter and measure a narrower groove. Therefore, the movable support structure 4 is designed as a height-adjustable structure, and moves up and down in the direction perpendicular to the surface of the polishing pad 2 during height adjustment.

The movable support structure 4 may be a polishing head 41, a polishing arm 42, a polishing slurry distribution arm 43, a dressing head 44, a dressing arm 45 or an independent support structure, which is not limited here.

When an average value of depths of grooves 21 in a specified range is less than a predetermined value or the number of grooves 21 with a depth less than a predetermined threshold value reaches a set number, the warning unit gives a warning to remind users to replace the polishing pad 2.

When the system for online inspection of the surface condition of the polishing pad is used, the sensor probe 12 is installed at a fixed distance from the polishing pad 2, which is within a detection range of the optical sensor 1. The optical unit 11 of the optical sensor 1 emits a light beam, which is focused into a tiny spot through the sensor probe 12 and shine on the polishing pad 2. After being reflected by the surface characteristics of the polishing pad 2, reflected light beams of different characteristics are received by the sensor probe 12 and then transmitted to the optical unit 11 again, so that the wavelength, intensity and spot position of the reflected light beams can be detected. The control unit 13 controls the optical unit 11 to emit, receive and detect light beams, and obtains distances between the sensor probe 12 and various liquid surface distribution areas on the polishing pad 2 based on the detected information, thus realizing the distance measurement function of the optical sensor 1. The processing unit 3 receives the distance information measured by the optical sensor 1 for subsequent analysis of the surface condition of the polishing pad 2.

The movable support structure 4 drives the sensor probe 12 fixed thereon to move in a direction parallel to the polishing pad 2 according to a set movement path, so as to measure the distance information of the surface characteristics of corresponding local or overall areas of the polishing pad 2 along the movement path, including a distance between the sensor probe 12 and the liquid surface on the polishing pad 2, a distance between the sensor probe 12 and the polishing pad 2, and a distance between the sensor probe 12 and a bottom surface of the grooves 21 of the polishing pad 2. The movement path of the movable support structure 4 covers the entire range from the periphery to the center of the polishing pad 2, so that the optical sensor 1 fixed thereon can obtain the characteristic distance information of different parts of the polishing pad 2.

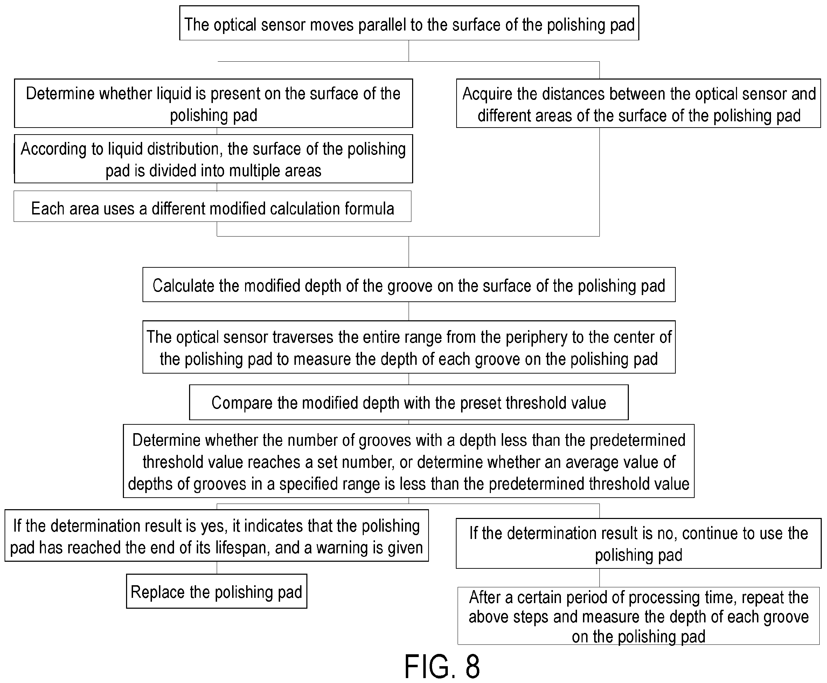

As shown in FIG. 8, a method for online inspection of a surface condition of a polishing pad comprises the following steps:
an optical sensor 1 moves above a polishing pad 2, specifically above the polishing pad 2 in a parallel orientation, in a radial direction of the polishing pad 2, and the movement covers the entire range from the periphery to the center of the polishing pad 2, thus obtaining the surface condition of the polishing pad 2 and a distance between the optical sensor 1 and a surface of the polishing pad 2;
according to the distribution of liquid on the surface of the polishing pad 2 and the measured distance information, depths of grooves 21 on the surface of the polishing pad 2 are calculated using different modified calculation formulas; and
a modified depth of the grooves 21 on the surface of the polishing pad 2 is compared with a predetermined threshold value, and whether the polishing pad 2 needs to be replaced is determined based on a depth condition of the grooves 21 on the polishing pad 2.

If an initial determination result indicates that no replacement is required, the above steps are repeated to inspect the depth condition of the grooves 21, and when the depth condition of the grooves 21 reaches a predetermined condition, a warning for replacing the polishing pad 2 is given by a warning unit.

Determining the depth condition of the grooves 21 on the polishing pad 2 is to determine whether the number of grooves 21 with a depth less than the predetermined threshold value reaches a set number, or determine whether an average value of depths of grooves 21 in a specified range is less than the predetermined threshold value. Here, the specified range can be an area of any size on the polishing pad 2.

Specifically, the optical sensor 1 moves above the polishing pad 2 to obtain the surface condition of the polishing pad 2, including the first information, second information, third information and fourth information.

As shown in FIG. 4, the first information is a distance between the optical sensor 1 and the surface of the polishing pad 2;
the second information is a distance between the optical sensor 1 and a liquid surface on the polishing pad 2;
in another word, when the sensor probe 12 is located above the polishing pad 2, the optical sensor 1 determines whether there is a liquid surface on the polishing pad 2 and measures the distance between the sensor probe 12 and the liquid surface on the polishing pad 2; meanwhile, the optical sensor 1 determines whether the polishing pad 2 exists and measures the distance between the sensor probe 12 and the polishing pad 2;
the third information is a distance between the optical sensor 1 and an inner bottom surface of the grooves 21; and
the fourth information is a distance between the optical sensor 1 and a liquid surface in the grooves 21;
in another word, when the sensor probe 12 is located above the grooves 21 of the polishing pad 2, the optical sensor 1 determines whether there is a liquid surface on the polishing pad 2 and measures the distance between the sensor probe 12 and the liquid surface on the polishing pad 2; meanwhile, the optical sensor 1 determines whether the bottom surface of the grooves 21 of the polishing pad 2 exists and measures the distance between the sensor probe 12 and the bottom surface of the grooves 21.

The formula for calculating the depth of the grooves 21 is: groove depth = the distance between the sensor probe and the bottom surface of the groove of the polishing pad - the distance between the sensor probe and the surface of the polishing pad (here referred to as the polishing surface of the polishing pad).

Due to the accumulation of polishing slurry on the surface of the polishing pad 2 and the varying amounts of polishing slurry accumulation in different areas, the surface condition of the polishing pad 2 generally comprises one or a combination of the following three. The optical sensor 1 analyzes the distribution of the liquid on the surface of the polishing pad 2 based on the measured distance information.

In a first case, the liquid is present in the grooves 21, and overflows to cover the surface of the polishing pad 2, as shown in FIG. 5. In the first case, the optical sensor 1 obtains the first information, the second information, the third information and the fourth information, and the corresponding modified formula is: modified groove depth = original groove depth × liquid refractive index.

In a second case, the liquid is present in the grooves 21, but the grooves 21 are not completely filled, as shown in FIG. 6. In the second case, the optical sensor 1 obtains the first information, the third information and the fourth information, and the corresponding modified formula is: modified groove depth = original groove depth h1+ (the distance between the optical sensor and the bottom surface of the groove of the polishing pad h2 - the distance between the optical sensor and the liquid surface on the polishing pad h3) × (liquid refractive index-1).

In a third case, no liquid is present in the grooves 21, as shown in FIG. 7. In the third case, the optical sensor 1 obtains the first information and the third information, and the corresponding modified formula is: modified groove depth = original groove depth.

The above specific embodiments are used to explain the invention, but not to limit it. Any modification and change made to the invention within the spirit of the invention and the scope of protection of the Claims of the invention fall within the scope of the invention.

## Claims

1. A method for online inspection of a surface condition of a polishing pad, **characterized in that**, comprising the following steps:
moving an optical sensor above the polishing pad to obtain a distance measurement between the optical sensor and the surface of the polishing pad;
analyzing distribution of the liquid on the surface of the polishing pad based on the distance measurement, and calculating depths of the grooves on the surface of the polishing pad using different modified calculation formulas; and
comparing the depths of the grooves on the surface of the polishing pad with a predetermined threshold value, and determining whether the polishing pad needs to be replaced or reworked.

2. The method for online inspection of the surface condition of the polishing pad according to Claim 1, **characterized in that**, comparing the depths of the grooves on the surface of the polishing pad with a predetermined threshold value is to determine whether number of the grooves with the depths of the grooves less than the predetermined threshold value reaches a set number, or to determine whether an average value of the depths of the grooves in a specified range is less than the predetermined threshold value.

3. The method for online inspection of the surface condition of the polishing pad according to Claim 1, **characterized in that**
the distance measurement between the optical sensor and the surface of the polishing pad acquired during movement of the optical sensor is used as a first information;
or/and a distance measurement between the optical sensor and a surface of the liquid on the polishing pad acquired during movement of the optical sensor is used as a second information;
or/and a distance measurement between the optical sensor and a bottom surface of the grooves acquired during movement of the optical sensor is used as a third information;
or/and a distance measurement between the optical sensor and a liquid surface in the grooves acquired during movement of the optical sensor is used as fourth information.

4. The method for online inspection of the surface condition of the polishing pad according to Claim 3, **characterized in that**, distribution patterns of the liquid on the surface of the polishing pad comprise at least one of the following three cases:
in a first case, the liquid is present in the grooves, and overflows to cover the surface of the polishing pad;
in a second case, the liquid is present in the grooves, but the grooves are not completely filled; and
in a third case, the liquid is not present in the grooves.

5. The method for online inspection of the surface condition of the polishing pad according to Claim 4, **characterized in that**,
the optical sensor analyzes the distribution of the liquid on the surface of the polishing pad:
in the first case, the first information, the second information, the third information and the fourth information are acquired;
in the second case, the first information, the third information and the fourth information are acquired; and
in the third case, the first information and the third information are acquired.

6. The method for online inspection of the surface condition of the polishing pad according to Claim 5, **characterized in that**,
in the first case, the depths of the grooves = the measured depths of the grooves × liquid refractive index;
in the second case, the depths of the grooves = the measured depths of the grooves + (the distance between the optical sensor and the bottom surface of the grooves - the distance between the optical sensor and the liquid surface on the polishing pad) × (liquid refractive index-1); and
in the third case, the depths of the grooves = the measured depths of the grooves.

7. The method for online inspection of the surface condition of the polishing pad according to Claim 1, **characterized in that**, the above steps are repeated, and when the depths of the grooves reach a predetermined condition, a warning for replacing the polishing pad is given.

8. The method for online inspection of the surface condition of the polishing pad according to Claim 1, **characterized in that**, the optical sensor moves above the polishing pad in a direction which is parallel to and above the polishing pad, and the moving range traverses from a periphery of the polishing pad to a center of the polishing pad.

9. A system for online inspection of a surface condition of a polishing pad, **characterized in that**, comprising:
an optical sensor at least comprising an optical unit, a sensor probe and a control unit,
the optical unit being used for emitting a light beam to a surface of the polishing pad,
the sensor probe being used for focusing the light beam emitted by the optical unit and shining the light beam on the polishing pad, and receiving a reflected light signal and transmitting the reflected light signal to the optical unit,
the control unit being used for acquiring distance information between the sensor probe and the surface of the polishing pad;
a processing unit connected with the optical sensor and used for analyzing the distance information between the sensor probe and the surface of the polishing pad and calculating depths of the grooves on the surface of the polishing pad according to different modified calculation formulas; and
a movable support structure used for driving the optical sensor to move above the polishing pad.

10. The system for online inspection of the surface condition of the polishing pad according to Claim 9, **characterized in that**, the modified calculation formulas correspond to a distribution pattern of a liquid on the surface of the polishing pad, and the distribution patterns comprise the following:
in a first case, the liquid is present in the grooves, and overflows to cover the surface of the polishing pad;
in a second case, the liquid is present in the grooves, but the grooves are not completely filled; and
in a third case, the liquid is not present in the grooves.

11. The system for online inspection of the surface condition of the polishing pad according to Claim 9, **characterized in that**, the optical sensor adopts a spectral confocal technology.

12. The system for online inspection of the surface condition of the polishing pad according to Claim 9, **characterized in that**, the movable support structure drives the optical sensor to move in a direction which is mostly parallel to the polishing pad, from a periphery to a center of the polishing pad, and a height of the movable support structure is adjustable.

13. The system for online inspection of the surface condition of the polishing pad according to Claim 9, **characterized in that**, the movable support structure is a polishing head, or a polishing arm, or a polishing slurry distribution arm, or a dressing head, or a dressing arm, or an independent support structure.

14. The system for online inspection of the surface condition of the polishing pad according to Claim 9, **characterized in that**, the sensor probe is covered with a transparent protective layer, and the system further comprises a cleaning unit for cleaning the sensor probe or the transparent protective layer.

15. The system for online inspection of the surface condition of the polishing pad according to Claim 9, **characterized in that**, further comprising a warning unit which gives a warning signal when an average value of the depths of the grooves in a specified range is less than a predetermined value or a number of the grooves have the depths of the grooves less than a predetermined threshold value.
